# EUROPEAN PATENT APPLICATION

(11) **EP 1 029 941 A2**
(43) Date of publication of application: **23.08.2000**
(21) Application number: 00830040.2
(22) Date of filing: 24.01.2000
(51) Int. Cl.: C23C 14/32, C23C 14/56, C23C 14/58

(54) **Thin film deposition plant with differentiated sectors for plasma assisted techniques**

(30) Priority: 16.02.1999 IT RM990106
(71) Applicant: CE.TE.V. CENTRO TECNOLOGIE DEL VUOTO, I-61067 Carsoli (AQ) (IT)
(72) Inventor: Misiano, Carlo, 00161 Roma (IT)

(57) **Abstract**

Thin film deposition plant with differentiated sectors for plasma assisted techniques, having a rotating substrates holder, electrically polarised through a Dc or RF generator in which substrates are alternatively exposed, in environment with differentiated pressures and atmospheres. In this plant thin films deposition processes and/or plasma assistance for the film growth are effected. The substrates are exposed to a deposition source in controlled atmosphere then, passing through a pumping sector, are exposed to a plasma, having said plasma, more than one function, for instance to complete the oxidation of a metallic film deposed in partially reactive conditions in the other sector; or to induce a partially organic deposit by PECVD which results mixed with the inorganic film deposed in an other sector. The invention lies in the technical field of under vacuum thin films treatments and its application is in the field of realisation of the optical, tribological, for microelectronics, and for decorations treatments.

## Description

The invention relates to a thin film deposition plant with differentiated sectors, with plasma assisted techniques. The aim of the invention is to solve both research and production problems, in the realisation of vacuum treatments for thin films in the field of optics, microelectronics and tribology.

The invention lies in the technical field of thin film vacuum coating treatments and it finds its application in the tribological, optical field, for microelectronics realisation, as well as for decoration.

One of the problems solved by the invention is in the sector of the reactive depositions.

"Reactive deposition", as known, means a vacuum process in which a material, generally metallic, is vaporized. Said material is modified during its growth on the substrate, by means of a reactive atmosphere, a plasma assistance or through an ion gun bombardment.

One of the limitations about this kind of reactive process refers to the maximum rate of deposition obtainable which is strongly limited by the need of obtaining the full reaction of the film deposited. In fact, to increase the reactivity ambient, it has to be increased the reactive atmosphere pressure; but this aspect contrasts with the requirements of the vaporising sources which, in the case of use of sputtering sources, it is superficially contaminated by reactive gas, causing a strong reduction in the sputtering rate. Recent scientific publications show how to obtaining the optimisation of the ratio between reactive gas partial pressure and the source sputtering rate. They use sophisticated diagnosis and control methods which do not solve the problem but simply they allow to work in the zone of most favourable parameters without risks.

In the case, on the contrary, of thermal sources the reactive gas pressure limit is determined by the need to do not slow down, due to the collision, the particles of the vaporised material, thus producing a film with poor mechanical properties.

An other solution of this problem has been developed through the process METAMODE® of OCLI USA. This process, for its complexity, results too expensive and does not present, with respect to the solution of the inventor, the advantage to depose particles energization of the depositing material, thus obtaining the best qualities of the film deposited in terms of adhesion, compactness, stability and hardness and allowing, in addition, to carry out depositions on substrates not warmed before and drastically reducing sensibly the duration of the realization cycle. The present invention overcomes these limits as it uses differentiated sectors in order of pressure and composition of the residual atmosphere, allowing, in one of the plant sectors, to depose the vaporised material both through sputtering or thermal evaporation, or even arc source, in accordance with an Ion Plating Plasma Assisted configuration, and, in an other sector, to end the reactive process in environment with plasma at a pressure higher than that one in the deposition sector. The substrate results also bombarded by energized ions of the reactive gas which (ions) constitute the plasma, so accelerating the reaction process.

In this new type of process the substrates are surrounded by a plasma generated from the substrate holder polarisation and by the presence of a gaseous and reactive, or not, atmosphere.

During the deposition phase a percentage of the vaporised material results ionised by the same source (sputtering or cathodic arc), but, in any case, it is partially ionised, passing through the plasma and then the ionised particles are energized for acceleration owing to the substrates electrical polarisation.

In addition, the growing film results to be bombarded by the gas ions which constitute the plasma, obtaining both an effect of adatomi energization, and creating a first phase of reactivity.

In these conditions, the maximum usable deposition rate, is such to do not allow the fully total reactivity, which will be obtained during their passage in the other sectors. An other significant utilisation of the invention lies in the possibility to effect a codeposition mixed of inorganic films and partially organic films, utilising sector B for a "Plasma Enhanced Chemical Vapor Deposition" and the sector A for a Physical Vapor Deposition. In this way the substrate is periodically exposed to the deposition of a partially organic film in sector B and an inorganic film in sector A so forming a close mixture of the two deposits, that presents new and different optical, mechanical and electrical properties, in respect of the previous techniques, as for example, the Patent N° 96A000240 of the same assignee, can be cited: "Method for optical film deposition with mixed organic-inorganic structure".

In addition, the above described configuration allows a sequential deposition not mixed of deposited film by PECVD and by a PVD technique, as an hardening film for an optical plastic material substrate by PECVD, and a multilayer with optical properties by PVD techniques.

The invention is in the following described, as for the drawings here attached and in order of a version actually preferred by the inventor.

Fig. 1 - View of the plant with differentiated sectors.

Fig. 2 - One of the realisable configurations of the deposition plant.
- 1: vacuum chamber
- 2: substrate holder
- 3: substrates
- 4: feed-through, RF or DC electrically polarised
- 5: matching network to connect RF generator (absent if DC is used)
- 6: sectors walls
- 7: sector atmosphere container
- 8: vaporisation sources
- 9: process gas inlet
- 10: process and/or PECVD precursors gas inlet
- 11: vacuum pumping connection
- 12: plasma
- 13: lid

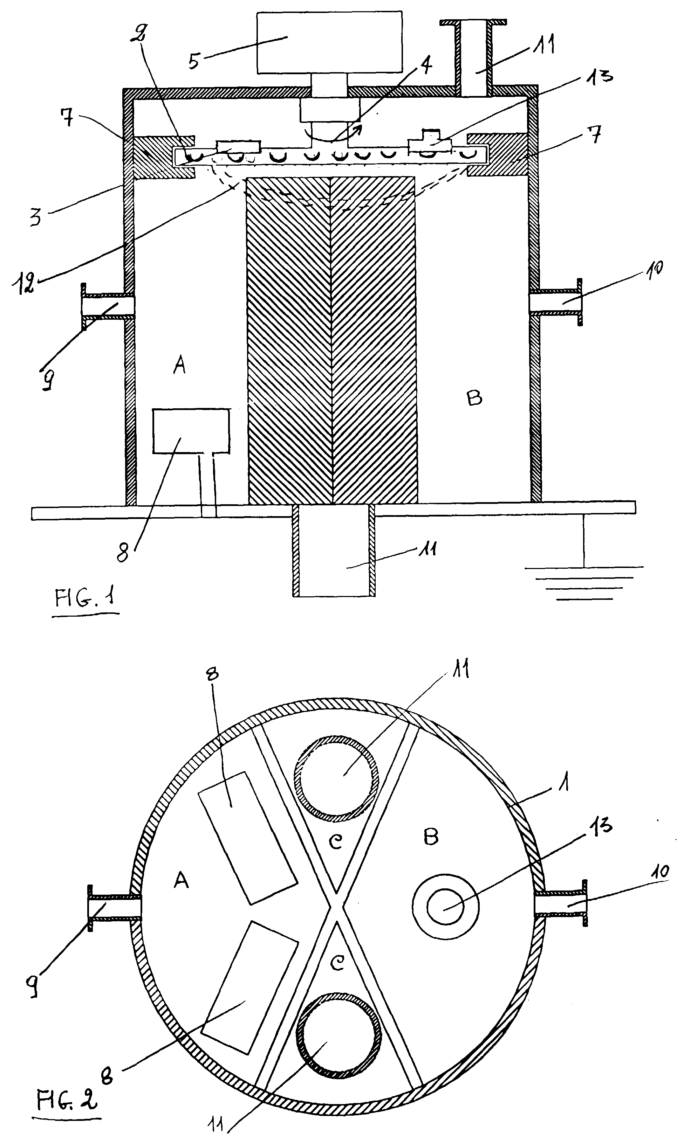

The invention is original because it comprises, under vacuum, two or more zones with differentiated atmospheres, for pressure and for chemical composition, so that, the substrates which must be covered by a thin film treatment, are continuously and alternatively exposed to two or more different atmospheres , excited by an electrical polarisation so to generate a plasma.

This differentiation of the atmosphere of these two or more sectors, is obtained creating an impedance to the gaseous flow and interposing pumping sectors C between the process sectors A and B, at different atmosphere. To obtain a high impedance to the gaseous flows between A and B sectors, in addition to the walls 6 shaped as L, in the superior part elements 7 shaped as C, are introduced. They constitute a labyrinth for the gaseous flow, and in addition, all the housings of the substrates must result blocked or by the same substrate or by a lid 13.

The deposition plant, of which at present request for patent, comprises a vacuum structure subdivided in differentiated sectors A and B, having a rotating substrates holder 2, electrically polarised through a generator, equipped, if in RF mode, with a matching network 5. The substrates holder 5 expose alternatively the substrates to the sectors with differentiated pressure and atmosphere.

In some sectors A and B, thin films deposition processes and/or plasma assistance are effected for their realisation. The substrates are alternatively exposed to a deposition source in a controlled atmosphere, then, passing through a pumping sector they are exposed to a plasma. This plasma has more then one function.

It is useful to point out the signification of the "controlled atmosphere". For controlled atmosphere, it means a reduced pressure by means a dynamic pumping, followed by the introduction of a process gas which will be dynamically pumped too.

To make easier the understanding of the above described plant, and the way to utilise it, some of the possible processes which can be realised by said plant are going to be described in the following:
- in sector A a deposition of a thin film partially oxidized or nitrited by a source of metal vaporization, is effected according to an Ion Plating Plasma Assisted configuration, while, after the passage through the pumping sector C, the reaction is completed in sector B, the oxidation, nitriding, etc. by exposition to a reactive plasma, at a reactive gas pressure higher then the pressure of the sector A;
- in sector A the deposition of an inorganic, dielectric or metallic film is effected by a PVD techniques, in sector B, the deposition of a partially organic film is effected by a PECVD technique, in order to obtain, finally, a closely mixed layer to a mixed organic-inorganic composition;
- a sequential deposition is effected in order to deposit on substrates, in a single vacuum cycle, multilayer structure at homogeneous films, deposing in sector B, semi-organic films by PECVD techniques, and deposing organic films with PVD technique, plasma assisted or not assisted.

The plant comprises a circular substrates holder 2, rotating, polarisable, which rotates, passing close, without direct contact, to the elements 7 shaped as C, and the upper part shaped as L of the sectors walls, by walls 6 which go from the base until to graze the substrates holder confining in a side with sector A and in the other side with sector B, defining the pumping area, being these walls at vacuum seal, except in the side grazing the rotating substrates holder. The substrates holder 2 is supported by a vacuum rotating feed through 4, isolated so to be polarized in DC and in RF. In addition, this plant is equipped with gas and/or precursors inlets 9 and 10, vaporizing sources 8 which can be sputtering, arc or thermal, and a high vacuum pumping group.

## Claims

1. Vacuum deposition plant for thin films, subdivided in sectors (A, B) by a separation structure, comprising a rotating substrates holder (2), electrically polarisable, a matching network (5) for the connection to the RF generator, material vaporization sources (8), inlets (9) for processing gases and/or organic precursors, with relative pressure and/or flow gauges; a pumping group in which said sectors are maintained in pressure and atmosphere compositions even quite different, by means a differential pumping, separated inlets for gases or gaseous precursors; in which said polarised substrates holder exposes, alternatively, said substrates to the different sectors, in which said substrates holder, being electrically polarised, generates in front of its surface and in front of the substrates surface, a plasma of different composition and pressure depending to the sectors in which, in one or more of said sectors, one or more PVD sources are lied; in which in one or more of said sectors gases or organic precursors are introduced to obtain a plasma chemical deposition (PVD).

2. Vacuum deposition plant for thin films, with plasma assisted techniques, as for Claim 1, characterised by the fact that one of the processes can be realised as in the following: in the sector A is effected the deposition of a thin film partially oxidised or nitrited by a metal vaporization source, according to an ion plating plasma assisted configuration, while, after the passage through the pumping sector C, in the sector B the reaction, oxidation, nitriding, etc. is completed, by means an exposition to a reactive plasma at a reactive gas pressure generally higher then that one of the sector A.

3. Vacuum deposition plant for thin films, with plasma assisted techniques, as for Claim 1, characterised by the fact that one of the processes can be realised as in the following: In sector A is effected a deposition of an inorganic film, dielectric or metallic by a PVD technique, and in sector B the deposition of a partially organic film by a PECVD technique, in order to obtain a closely mixed layer with a mixed organic-inorganic composition.

4. Vacuum deposition plant for thin films, with plasma assisted techniques, as for Claim 1, characterised by the fact that one of the processes can be realised as follow: a sequential deposition is effected in a single vacuum cycle; in order to depose on the substrates multilayer structures at homogeneous films, deposing in sector B semi-organic films by PECVD technique, and in sector A inorganic films by a PVD technique, with or without plasma assistance.
